# FASCICULE DE BREVET EUROPEEN

(11) **EP 3 473 592 B1**
(45) Date de publication et mention de la délivrance du brevet: **19.04.2023**
(21) Numéro de dépôt: 18200404.4
(22) Date de dépôt: 15.10.2018
(51) Int. Cl.: B82Y 10/00, H01L 29/06, H01L 29/76, H01L 29/423

(54) **DISPOSITIF QUANTIQUE A QUBITS DE SPIN COUPLES DE MANIERE MODULABLE**
QUANTENVORRICHTUNG MIT MODULIERBAR GEKOPPELTEN SPIN-QUBITS
QUANTUM DEVICE WITH SPIN QUBITS COUPLED IN A SCALABLE MANNER

(30) Priorité: 18.10.2017 FR 1759789
(43) Date de publication de la demande: 24.04.2019
(73) Titulaire: Commissariat à l'énergie atomique et aux énergies alternatives, 75015 Paris (FR)
(72) Inventeur: HUTIN, Louis, 38950 SAINT-MARTIN-LE-VINOUX (FR); JEHL, Xavier, 38360 NOYAREY (FR); VINET, Maud, 38640 CLAIX (FR)
(74) Mandataire: Brevalex

(56) Documents cités:
- US-A- 3 787 962
- US-A- 5 447 876
- US-A1- 2002 179 897
- US-A1- 2010 270 534
- US-A1- 2015 279 981
- HUTIN L ET AL: "SOI CMOS technology for quantum information processing", 2017 IEEE INTERNATIONAL CONFERENCE ON IC DESIGN AND TECHNOLOGY (ICICDT), IEEE, 23 mai 2017 (2017-05-23), pages 1-4, XP033131249, DOI: 10.1109/ICICDT.2017.7993523
- R. MAURAND ET AL: "A CMOS silicon spin qubit", NATURE COMMUNICATIONS, vol. 7, 24 novembre 2016 (2016-11-24), page 13575, XP055481105, GB ISSN: 2041-1723, DOI: 10.1038/ncomms13575
- M. VELDHORST ET AL: "A two-qubit logic gate in silicon", NATURE, vol. 526, 15 octobre 2015 (2015-10-15), pages 410-414, XP055481114,
- RAN YAN ET AL: "LDD and Back-Gate Engineering for Fully Depleted Planar SOI Transistors with Thin Buried Oxide", IEEE TRANSACTIONS ON ELECTRON DEVICES, IEEE SERVICE CENTER, PISACATAWAY, NJ, US, vol. 57, no. 6, 1 June 2010 (2010-06-01), pages 1319-1326, XP011308116, ISSN: 0018-9383
- YIONG W ET AL: "Self-aligned ground-plane fdsoi mosfet", 2002 IEEE INTERNATIONAL SOI CONFERENCE PROCEEDINGS. WILLIAMSBURG, VA, OCT. 7 - 10, 2002; [IEEE INTERNATIONAL SOI CONFERENCE], NEW YORK, NY : IEEE, US, 7 October 2002 (2002-10-07), pages 23-24, XP010610992, ISBN: 978-0-7803-7439-3
- OTHMAN NORAINI ET AL: "UTBB SOI MOSFETs with gate-source/drain underlap and ground plane (GP) structures for analog/RF applications", 2016 IEEE INTERNATIONAL CONFERENCE ON SEMICONDUCTOR ELECTRONICS (ICSE), IEEE, 17 August 2016 (2016-08-17), pages 133-136, XP032969149, DOI: 10.1109/SMELEC.2016.7573609 [retrieved on 2016-09-21]
- FENOUILLET-BERANGER C ET AL: "FDSOI devices with thin BOX and ground plane integration for 32nm node and below", SOLID STATE ELECTRONICS, ELSEVIER SCIENCE PUBLISHERS, BARKING, GB, vol. 53, no. 7, 1 July 2009 (2009-07-01), pages 730-734, XP026145464, ISSN: 0038-1101, DOI: 10.1016/J.SSE.2009.02.009 [retrieved on 2009-04-25]
- VINET M ET AL: "Self-Aligned Planar Double-Gate MOSFETs by Bonding for 22-nm Node, With Metal Gates, High-Dielectrics, and Metallic Source/Drain", IEEE ELECTRON DEVICE LETTERS, IEEE, USA, vol. 28, no. 7, 1 July 2009 (2009-07-01), pages 748-750, XP011263273, ISSN: 0741-3106

## Description

### DOMAINE TECHNIQUE ET ART ANTÉRIEUR

L'invention concerne le domaine de la spintronique, et notamment du traitement de l'information quantique, ou de l'informatique quantique. L'invention porte notamment sur un dispositif quantique à bits quantiques (appelé quantum bits) ou qubits de spin, couplés entre eux de manière modulable.

Pour qu'un dispositif quantique à qubits de spin, également appelés boîtes quantiques ou « quantum dots », puisse réaliser des fonctions logiques quantiques, il est nécessaire de :
- définir un système quantique à deux niveaux, ou deux états (système binaire) ;
- être en mesure de manipuler l'état quantique des qubits ;
- être capable de détecter un changement des états quantiques des qubits ;
- pouvoir faire communiquer les qubits entre eux via un couplage quantique ajustable ou modulable.

Le document « SOI technology for quantum information processing » de S. De Franceschi et al., Electron Devices Meeting (IEDM), 2016 IEEE International, pp. 13.4.1 - 13.4.4, décrit un dispositif quantique réalisé en technologie FDSOI dans lequel deux qubits reliés en série l'un à l'autre sont réalisés dans une zone active d'un substrat SOI recouverte par deux grilles permettant de commander ces deux qubits. Des régions de source et de drain réalisées dans la zone active forment des réservoirs de porteurs de charge pour ces deux qubits. Dans un tel dispositif, le couplage quantique entre les deux qubits n'est pas ajustable ou modulable. Ces qubits ne peuvent donc pas communiquer entre eux et ils ne peuvent être utilisés que sous la forme d'un qubit unique.

Le document "SOI CMOS technology for quantum information processing" de L. Hutin et al., 2017 IEEE INTERNATIONAL CONFERENCE ON IC DESIGN AND TECHNOLOGY (ICICDT), IEEE, 23 mai 2017, pages 1-4, DOI: 10.1109/ICICDT.2017.7993523 décrit un dispositif similaire comprenant en plus une grille arrière de type "ground plane". Ce document décrit aussi un autre dispositif quantique en technologie FDSOI comprenant plusieurs qubits réalises dans une zone active d'un substrat SOI et plusieurs grilles arrière formées dans la couche support du substrat SOI et alignées aux régions de séparation entre les portions de semi-conducteur ou les qubits sont réalisés. Les grilles avant de ce dispositif sont du type "split gâte".

Le document « A two-qubit logic gate in silicon » de M. Veldhorst et al., Nature 526, 410-414 (2015), propose de contrôler le couplage entre deux qubits en superposant, au-dessus des grilles de commande de ces qubits, des grilles supplémentaires disposées sur une couche diélectrique assurant l'isolation électrique entre les grilles de commande et ces grilles supplémentaires. Cette configuration engendre toutefois un fort couplage capacitif entre les grilles superposées.

### EXPOSÉ DE L'INVENTION

Un but de la présente invention est de proposer un dispositif quantique à qubits de spin couplés entre eux tels que ce couplage soit modulable, et ne présentant pas les inconvénients des dispositifs quantiques de l'art antérieur exposés ci-dessus.

Pour cela, la présente invention propose un dispositif quantique selon la revendication 1.

Dans ce dispositif, le couplage entre les régions de confinement des qubits, c'est-à-dire les régions dans chacune desquelles une charge est destinée à être piégée en formant un puits de potentiel sous une des grilles avant, est ajustable grâce à une barrière tunnel formée par la région de couplage (qui correspond à la deuxième partie de la portion de semi-conducteur), le niveau de cette barrière tunnel étant ajustable en fonction du potentiel électrique appliqué sur la région dopée de la couche support qui se trouve sous cette barrière tunnel et qui agit par effet de champ (en raison de la couche diélectrique enterrée présente entre cette région dopée et la région de couplage) sur le niveau de cette barrière tunnel. La région de couplage forme ainsi une barrière pouvant être abaissée par la grille arrière de commande.

Ce dispositif ne comporte pas de superposition de grilles engendrant un couplage capacitif important entre celles-ci puisque les grilles avant ne sont pas superposées à la région dopée de la couche support formant la grille arrière de commande du couplage entre les régions de confinement des qubits. Le couplage capacitif entre les grilles avant et la grille arrière de commande est très faible par rapport au cas de grilles superposées et séparées par un oxyde mince.

Les qubits ne sont pas assimilables à des transistors CMOS reliés en série car un transistor CMOS requiert un réservoir de porteurs de charges de part et d'autre de son canal. Deux transistors MOS sont reliés en série l'un à l'autre en reliant nécessairement l'une des régions de drain et de source de l'un des deux transistors à l'une des régions de drain et de source de l'autre des deux transistors. Dans le dispositif quantique selon l'invention, aucun réservoir de porteurs de charges, formé par une région fortement dopée, n'est présent entre les premières parties de la portion de semi-conducteur qui forment les régions de confinement des qubits.

En outre, dans un transistor CMOS, une grille arrière sert à moduler le potentiel du canal et est donc localisée sous, ou à l'aplomb, du canal et ne peut pas être réalisée de manière auto-alignée par rapport à la grille avant du transistor. Dans le dispositif quantique selon l'invention, la région dopée formée dans la couche support est disposée au moins en partie sous, ou à l'aplomb de, la deuxième partie de la portion de semi-conducteur qui correspond à la région de couplage entre les qubits et non sous, ou à l'aplomb de, l'une des premières parties de la portion de semi-conducteur qui correspondent aux régions de confinement des qubits.

De plus, la région dopée formant la grille arrière de commande du couplage entre les régions de confinement des deux qubits est auto-alignée vis-à-vis des grilles avant, et donc également vis-à-vis de la deuxième partie de la portion de semi-conducteur qui forme la région de couplage entre les régions de confinement des deux qubits. Cette configuration permet d'éviter les risques de désalignement entre les grilles avant et la grille arrière, de tels désalignements pouvant créer des capacités parasites entre les grilles avants et arrières et une dissymétrie dans la zone de couplage entre les qubits, affectant les performances de ce couplage.

La portion de semi-conducteur peut comporter en outre au moins deux troisièmes parties dopées entre lesquelles sont disposées les premières et la deuxième parties et formant des réservoirs de porteurs de charges électriques des qubits.

Les premières et deuxième parties de la portion de semi-conducteur peuvent comporter un dopage résiduel inférieur ou égal à environ 1.10¹⁶ at.cm⁻³, et la région dopée de la couche support peut comporter un dopage supérieur ou égal à environ 1.10¹⁹ at.cm⁻³.

Le dispositif peut comporter en outre des espaceurs diélectriques entourant chacune des grilles avant et recouvrant la deuxième partie de la portion de semi-conducteur.

La région dopée peut comporter au moins une zone de contact disposée à côté de ladite partie se trouvant à l'aplomb de la deuxième partie de la portion de semi-conducteur, et reliée électriquement à au moins un contact électrique qui traverse au moins la couche diélectrique enterrée.

La couche support peut comporter plusieurs régions dopées formant plusieurs grilles arrière de commande du couplage entre des régions de confinement de plusieurs qubits. Dans ce cas, le dispositif quantique comporte plus de deux qubits couplés entre eux par différentes régions de couplage chacune modulable par l'intermédiaire d'une des grilles arrière de commande. Dans ce cas, au moins une partie de chacune des régions dopées est disposée à l'aplomb d'une des deuxièmes parties de la portion de semi-conducteur et auto-alignée vis-à-vis des grilles avant, et forme une grille arrière de commande du couplage entre les régions de confinement de deux des qubits.

Dans ce cas, chacune des régions dopées peut comporter au moins une zone de contact reliée électriquement à un contact électrique individuel compatible avec un adressage individuel des grilles arrière. Ainsi, les couplages entre les différents qubits peuvent être modulés individuellement.

L'invention concerne également un procédé de réalisation d'un dispositif quantique selon la revendication 8.

Un tel dispositif quantique peut être réalisé avec une technologie dérivée de celle des dispositifs CMOS. Par exemple, la région dopée peut être réalisée dans la couche support via un dopage local de type « ground plane », ou plan de masse, à travers la couche diélectrique enterrée après la réalisation des grilles avant, ou après la réalisation de grilles factices qui seront remplacées ensuite par les grilles avant, et avant la réalisation des espaceurs autour des grilles avant ou des grilles factices.

Les grilles avant sont réalisées avant le dopage de la région de la couche support.

Dans un deuxième exemple de réalisation, le procédé peut comporter, avant le dopage de la région de la couche support, une réalisation d'au moins deux grilles factices recouvrant chacune au moins partiellement l'une des deux premières parties de la portion de semi-conducteur, puis, après le dopage de la région de la couche support, une suppression des grilles factices puis la réalisation des grilles avant à des emplacements correspondant à ceux occupés par les grilles factices.

Le dopage de la région de la couche support peut comporter la mise en oeuvre des étapes suivantes :
- réalisation d'un masque comprenant au moins une ouverture formée à travers le masque ;
- implantation de dopants dans ladite région de la couche support dont le motif est défini par celui de l'ouverture traversant le masque et par celui des grilles avant ou des grilles factices.

La région dopée de la couche support formant la grille arrière de commande est réalisée de manière auto-alignée vis-à-vis des grilles avant, et donc auto-alignée vis-à-vis de la deuxième partie de la portion de semi-conducteur formant la région de couplage des qubits.

Le procédé peut comporter en outre, avant la réalisation des grilles avant ou des grilles factices, une étape de gravure d'une couche superficielle de semi-conducteur du substrat, au moins une portion restante de la couche superficielle formant la portion de semi-conducteur.

Le procédé peut comporter en outre, après l'étape de dopage de ladite région de la couche support, les étapes de :
- réalisation d'espaceurs diélectriques entourant chacune des grilles avant ou des grilles factices et recouvrant la deuxième partie de la portion de semi-conducteur ;
- dopage d'au moins deux troisièmes parties de la portion de semi-conducteur entre lesquelles sont disposées les premières et la deuxième parties et destinées à former des réservoirs de porteurs de charges électriques.

Une épitaxie peut être mise en oeuvre pour former les deux troisièmes parties de la portion de semi-conducteur.

Les étapes mises en oeuvre peuvent former plusieurs régions dopées de la couche support formant plusieurs grilles arrière de commande du couplage entre des régions de confinement de plusieurs qubits.

Dans ce cas, le procédé peut comporter en outre la réalisation de plusieurs contacts électriques individuels chacun relié électriquement à une zone de contact d'une des régions dopées de la couche support et compatible avec un adressage individuel des grilles arrières.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A et 1B représentent un dispositif quantique à qubits de spin couplés de manière modulable, objet de la présente invention, selon un premier mode de réalisation ;
- les figures 2A à 8B représentent les étapes d'un procédé de réalisation d'un dispositif quantique à qubits de spin couplés de manière modulable, objet de la présente invention, selon le premier mode de réalisation ;
- les figures 9 à 11 représentent des variantes de réalisation du dispositif quantique à qubits de spin couplés de manière modulable, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

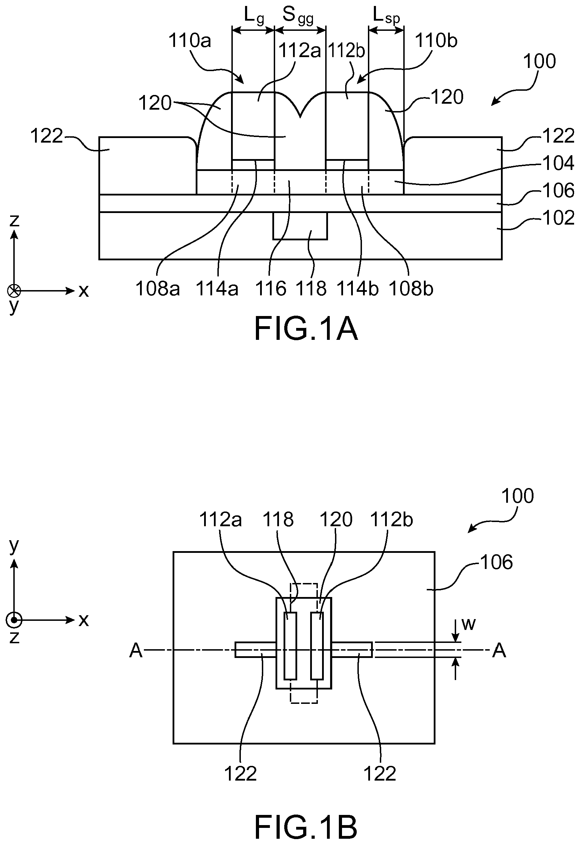

On se réfère tout d'abord aux figures 1A et 1B qui représentent respectivement une vue en coupe et une vue de dessus d'un dispositif quantique 100 à qubits de spin couplés de manière modulable, selon un premier mode de réalisation. La figure 1A est une vue en coupe selon un axe AA visible sur la figure 1B.

Le dispositif 100 est réalisé dans un substrat de type semi-conducteur sur isolant, par exemple SOI (silicium sur isolant). Ce substrat comporte une couche support 102, ou couche massive, de semi-conducteur et comprenant par exemple du silicium. Le substrat comporte également une couche superficielle de semi-conducteur (non visible sur les figures 1A et 1B), comprenant par exemple du silicium, à partir de laquelle est réalisée une portion 104 de semi-conducteur. Une couche diélectrique enterrée 106 est disposée entre la couche support 102 et la couche superficielle de semi-conducteur, et donc entre la couche support 102 et la portion 104. La couche diélectrique enterrée comporte par exemple de l'oxyde de silicium. L'épaisseur de la portion 104 (dimension selon l'axe Z sur les figures 1A et 1B), et donc également l'épaisseur de la couche superficielle de semi-conducteur à partir de laquelle la portion 104 est réalisée, est par exemple comprise entre environ 6 nm et 20 nm. L'épaisseur de la couche diélectrique enterrée 106 est par exemple comprise entre environ 20 nm et 145 nm. L'épaisseur de la couche support 102 est par exemple égale à plusieurs centaines de microns.

Dans le premier mode de réalisation décrit ici, le dispositif 100 comporte deux qubits de spin. Chacun des qubits comprend une région de confinement formée par une première partie de la portion 104. Sur la figure 1A, deux premières parties de la portion 104 sont référencées 108a et 108b et appartiennent chacune à l'un des deux qubits du dispositif 100. Sur la figure 1A, ces deux premières parties 108a, 108b sont délimitées de manière symbolique (du fait que la nature du semi-conducteur des premières parties 108a, 108b est similaire à celle du reste du semi-conducteur de la portion 104) par des traits pointillés. Chacun des qubits comprend également une grille avant, référencées 110a et 110b sur la figure 1A. Chacune des grilles avant 110a, 110b comporte une portion conductrice 112a, 112b et un diélectrique de grille 114a, 114b interposé entre la portion conductrice 112a, 112b et la première partie 108a, 108b de la portion 104.

Les deux qubits du dispositif 100 sont reliés en série l'un à l'autre par l'intermédiaire d'une deuxième partie 116 de la portion 104, formant une région de couplage entre les régions de confinement (les premières parties 108a, 108b) des deux qubits. Comme le semi-conducteur des premières parties 108a, 108b, le semi-conducteur de la deuxième partie 116 n'est pas dopé intentionnellement. Seul un dopage résiduel est présent dans les premières et deuxième parties 108a, 108b, 116 de la portion 104 et est par exemple inférieur ou égal à environ 10¹⁶ at.cm⁻³.

Le couplage quantique entre les régions de confinement 108a, 108b réalisé par la deuxième partie 116, ou plus particulièrement le niveau de la barrière tunnel formée par la deuxième partie 116 entre les régions de confinement 108a, 108b est modulable grâce à une région dopée 118 de la couche support 102. Une partie de cette région 118 est disposée à l'aplomb de, ou en regard de, ou sous, la deuxième partie 116 de la portion 104. Ainsi, la projection de cette partie de la région 118 dans un plan parallèle au plan (X,Y) ou parallèle à l'interface entre la couche support 102 et la couche diélectrique enterrée 106, est superposée à la projection de la deuxième partie 116 de la portion 104 dans ce même plan.

En outre, la région 118 est ici auto-alignée par rapport aux grilles avant 110a, 110b. Ainsi, en projetant la région 118 et les grilles avant 110a, 110b dans un même plan parallèle au plan (X,Y), les bords d'une partie de la région 118 ainsi projetée sont alignés avec ceux de la projection des grilles avant 110a, 110b dans ce plan. De plus, la partie de la région 118 qui est disposée à l'aplomb de la deuxième partie 116 de la portion 104 est également auto-alignée avec cette deuxième partie 116.

La région 118 correspond avantageusement à une région dopée localement du semi-conducteur de la couche support 102. Le dopage réalisé pour former la région 118 est important et avantageusement supérieur à environ 10¹⁹ at.cm⁻³, et cela afin d'éviter le gel des porteurs de charges à basse température. Le niveau de dopage de la région 118 est suffisamment grand pour que le temps de charge (durée RC) soit faible devant le temps caractéristique de la mesure. En effet, en considérant qu'à l'ordre zéro une manipulation sur la grille arrière (lecture de charge ou échange de charge) doit être plus courte que le temps après lequel un spin perd sa cohérence, le temps de charge est choisi court, par exemple de l'ordre d'environ 1 ns, devant le temps caractéristique de la mesure qui est par exemple de l'ordre de 100 ns. Les dopants implantés dans le semi-conducteur de la région 118 peuvent être de type n ou p. Le dopage de la région 118 est tel que cette région 118 est conductrice, la polarité des impuretés implantées pouvant être compensée par la tension appliquée sur la région 118.

De manière générale, la région 118 correspond à une région dopée électriquement conductrice formée au sein de la couche support 102, à proximité de l'interface entre la couche support 102 et la couche diélectrique enterrée 106 afin qu'elle soit proche de la deuxième partie 116 de la portion 104.

Dans le dispositif 100, la région 118 est réalisée de manière locale, auto-alignée vis-à-vis des différentes parties 108a, 108b, 116 de la portion 104 et des grilles avant 110a, 110b, et donc ciblée vis-à-vis de la barrière tunnel dont la transparence, ou le niveau, est destinée à être modulée.

Chacune des grilles avant 110a, 110b est entourée par un espaceur diélectrique 120 qui repose donc sur la portion 104 et sur la couche diélectrique enterrée 106. Enfin, des troisièmes parties 122 dopées de la portion 104 entre lesquelles sont disposées les premières et deuxièmes parties 108a, 108b, 116 de la portion 104 forment des réservoirs de porteurs de charge pour les qubits du dispositif 100.

Dans ce dispositif 100, suivant le type de qubits formés (singlet triplet, single electron), la commande de manipulation (singlet triplet) ou de lecture dans chaque qubits peut être réalisée par l'intermédiaire des grilles avant 110a, 110b. Par contre, la communication entre ces deux qubits est assurée par la région de couplage formée par la deuxième partie 116 de la portion 104 et commandée par la région 118 qui forme une grille arrière de commande de ce couplage quantique entre les régions de confinement des qubits. Cette grille arrière permet de régler le degré de couplage entre les deux boîtes quantiques formées par les premières parties 108a, 108b de la portion 104, via l'ajustement de la barrière tunnel qui les sépare (barrière tunnel formée par la deuxième partie 116 de la portion 104). Suivant la polarité appliquée sur la région 118, cette barrière tunnel peut être réduite (couplage fort) ou augmentée (couplage faible, confinement élevé), avec un couplage minimal vis-à-vis des autres jonctions tunnel ou des grilles avant des qubits.

A titre d'exemple, la longueur de grille Lg de chacune des grilles avant 110a, 110b, qui correspond également à la longueur de chacune des premières parties 108a, 108b de la portion 104, est comprise entre environ 10 nm et 60 nm. Cette longueur de grille Lg correspond à la dimension parallèle à la plus grande dimension de la portion 104, ou encore parallèle à la direction de déplacement des porteurs de charge au sein de la portion 104 (dimension parallèle à l'axe X sur les figures 1A et 1B).

La largeur W de la portion 104, c'est-à-dire la largeur des premières et deuxième parties 108a, 108b, 116 de la portion 104, est par exemple comprise entre environ 5 nm et 80 nm. Cette largeur W correspond à celle qui est perpendiculaire à la dimension Lg et à l'épaisseur de la portion 104. Sur les figures 1A et 1B, cette largeur W de la portion 104 est parallèle à l'axe Y représenté sur les figures 1A et 1B.

L'espace inter-grilles Sgg, qui correspond à l'espacement entre deux grilles avant voisines 110a, 110b et qui est également égal à la longueur de la deuxième partie 116, est par exemple compris entre environ 20 nm et 90 nm. Cet espace inter-grilles est parallèle à la longueur de grille Lg de chacune des grilles avant 110a, 110b, et donc parallèle à l'axe X représenté sur les figures 1A et 1B.

La longueur L_{SP} de chacun des espaceurs 120, qui correspond à la dimension de chacun des espaceurs 120 qui est parallèle à la longueur de grille Lg des grilles avant 110a, 110b et à l'espace inter-grilles Sgg, est par exemple supérieure à la moitié de l'espace inter-grilles Sgg, et par exemple supérieure à environ 20 nm.

Bien que non visibles sur les figures 1A et 1B, le dispositif 100 comporte des contacts électriques permettant d'appliquer et/ou de lire des potentiels électriques sur les différents éléments des qubits. Ainsi, des contacts électriques peuvent être reliés à chacune des grilles avant 110a, 110b afin de pouvoir appliquer un potentiel électrique de commande sur chacune de ces grilles avant 110a, 110b. D'autres contacts électriques reliés aux troisièmes parties 122 de la portion 104 peuvent servir à la lecture et l'écriture dans les qubits. Un autre contact électrique peut être relié à la région 118, par exemple au niveau d'une zone de contact de la région 118 qui n'est pas disposé à l'aplomb de la deuxième partie 116 de la portion 104, et ni à l'aplomb des espaceurs 120 afin que cette zone de contact soit accessible depuis la face avant du dispositif 100 en traversant la couche diélectrique enterrée 106.

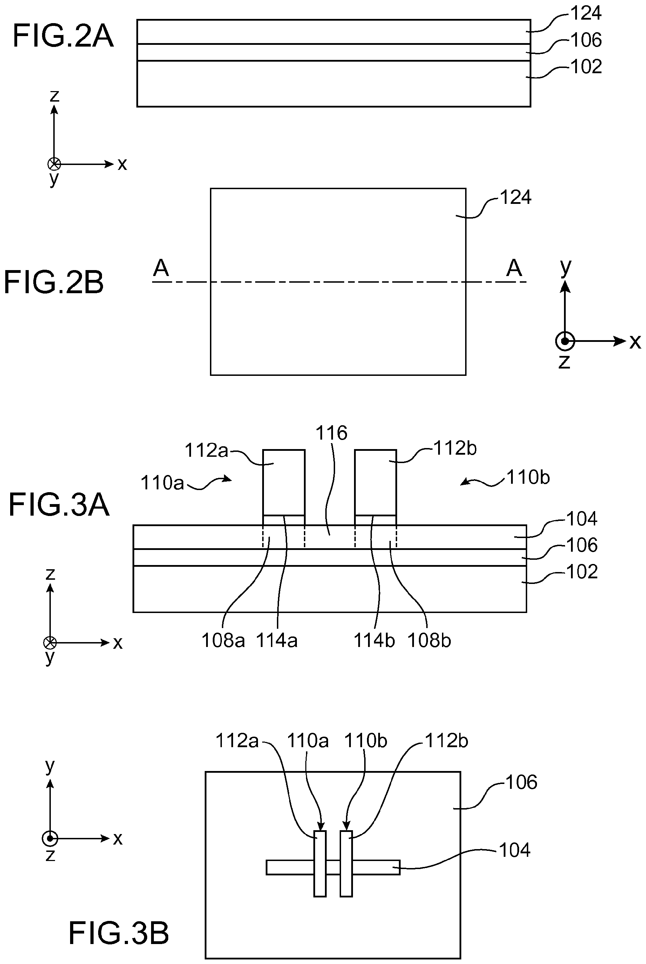

Un procédé de réalisation du dispositif 100 selon le premier mode de réalisation est décrit ci-dessous en lien avec les figures 2A à 8B. Les figures 2B, 3B, ..., 8B représentent des vues de dessus de la structure obtenue au fil des étapes mises en oeuvre, et les figures 2A, 3A, ..., 8A représentent des vues en coupe, selon l'axe AA visible sur la figure 2B, de cette structure.

Comme représenté sur les figures 2A et 2B, le procédé est mis en oeuvre à partir du substrat SOI précédemment décrit en lien avec les figures 1A et 1B, c'est-à-dire comprenant la couche support 102, la couche diélectrique enterrée 106, et la couche superficielle de semi-conducteur, ici référencée 124, à partir de laquelle la portion 104 est destinée à être réalisée.

La couche superficielle 124 est ensuite gravée afin de former la portion 104 dans laquelle les qubits du dispositif 100 seront réalisés

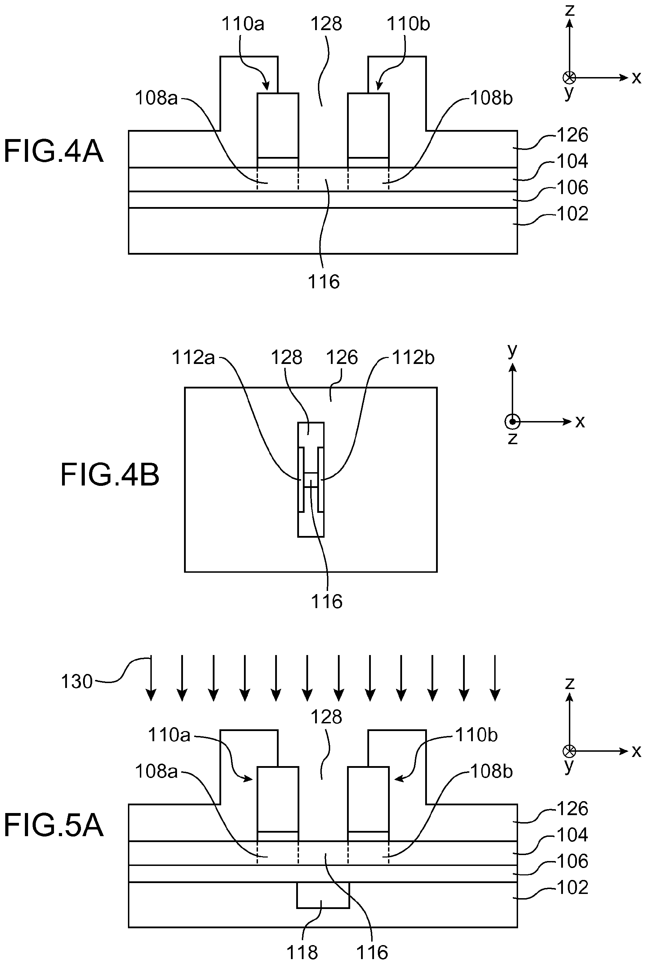

Sur les figures 3A, 4A, etc., seule une partie du dispositif 100 est représentée, cette partie du dispositif 100 correspondant à celle comprenant la portion 104. Les parties du dispositif 100 au niveau desquelles la couche superficielle de semi-conducteur 124 a été supprimée ne sont pas visibles sur ces figures.

Les grilles avant 110a, 110b sont ensuite réalisées. Ces grilles avant 110a, 110b s'étendent selon une direction (parallèlement à l'axe Y dans l'exemple décrit ici) sensiblement perpendiculaire à celle selon laquelle la portion 104 s'étend (parallèlement à l'axe X dans l'exemple décrit ici). Autrement dit, chacune des grilles avant 110a, 110b comporte une dimension principale sensiblement perpendiculaire à celle de la portion 104. Les parties de la portion 104 recouvertes par les parties centrales des grilles avant 110a, 110b correspondent aux premières parties 108a, 108b destinées à former les régions de confinement des qubits. Les premières parties 108a, 108b de la portion 104 sont séparées l'une de l'autre par la deuxième partie 116. Ces grilles avant 110a, 110b s'étendent, perpendiculairement à l'axe principale de la portion 104, sur des parties de la couche diélectrique enterrée 106 révélées par la précédente gravure de la couche superficielle 124 (figures 3A et 3B). Ces grilles avant 110a, 110b sont réalisées par des dépôts d'un matériau diélectrique de grille puis d'un matériau conducteur de grille, puis par une gravure de ces couches pour former les diélectriques de grille 114a, 114b et les portions conductrices de grille 112a, 112b. La mise en forme de ces éléments à partir des matériaux déposés peut être réalisée par lithographie à faisceau d'électrons, ou bien par lithographie hybride UV profond/faisceau d'électrons, ou par plusieurs étapes lithographiques de type UV profond.

Comme représenté sur les figures 4A et 4B, un masque 126 est ensuite réalisé sur la structure précédemment formée, afin de délimiter, avec les grilles avant 110a, 110b, la région 118 de la couche support 102 destinée à recevoir les dopants implantés. Une ouverture 128 formée à travers le masque 126 délimite, avec les grilles avant 110a, 110b, cette région 118. Sur l'exemple des figures 4A et 4B, le masque 126 est formé en recouvrant partiellement les grilles avant 110a, 110b afin d'avoir les bords des grilles avant 110a, 110b qui sont disposés l'une en face de l'autre qui ne soient pas recouverts par le masque 126 et qui permettent l'auto-alignement de la région 118 vis-à-vis de ces bords. Le masque 126 correspond par exemple à un masque dur comprenant un oxyde de semi-conducteur ou une résine photosensible. L'épaisseur du masque 126 est choisie en fonction du matériau utilisé et telle que les dopants implantés ultérieurement ne traversent pas ce masque 126.

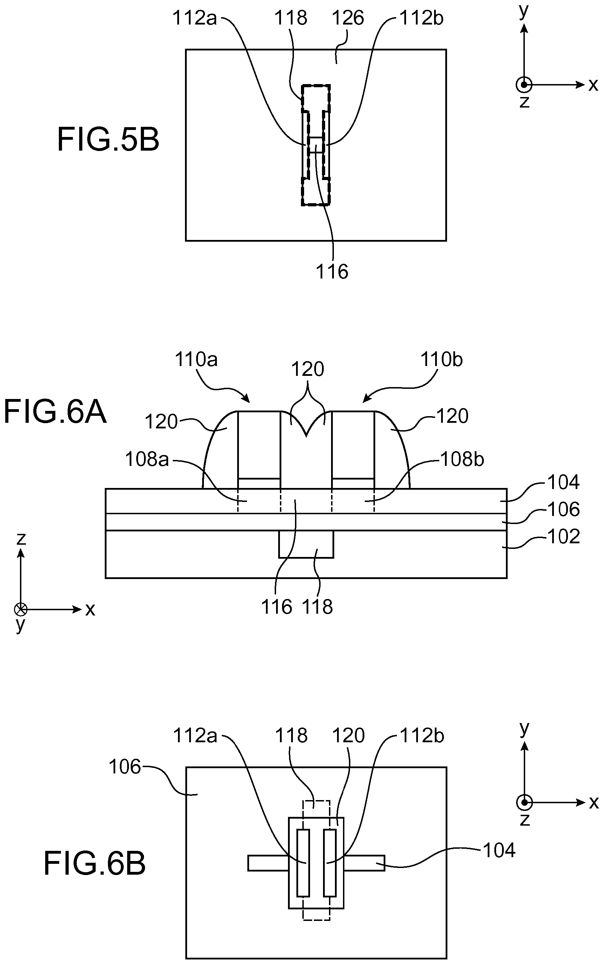

Sur les figures 5A et 5B, une implantation ionique est ensuite mise en oeuvre afin de former la région 118 dans la couche support 102. Sur la figure 5A, les faisceaux ioniques réalisant le dopage sont représentés symboliquement par des flèches référencées 130. Le masquage réalisé par le masque 126 et les grilles avant 110a, 110b empêche l'implantation des dopants sous ce masquage. Sur la figure 5B, la région 118 est représentée en trait pointillé.

La dose et l'énergie des faisceaux d'ions utilisés pour cette implantation sont ajustées afin de ne pas rendre amorphe le semi-conducteur de la portion 104 et de ne pas implanter de dopants, ou très peu de dopants, dans la portion 104. Le niveau de dopage toléré est tel qu'il soit improbable de trouver un dopant dans la deuxième partie 116. Par exemple, si cette deuxième partie 116 a pour dimensions 20 nm * 80 nm * 90 nm, la concentration maximale de dopants tolérés dans cette deuxième partie 116 est d'environ 7.10¹⁵ at.cm⁻³. Ces paramètres d'implantation sont choisis tels que la distribution des dopants implantés soit maximale dans le semi-conducteur de la couche support 102 se trouvant du côté de l'interface arrière de la couche diélectrique enterrée 106, formant alors la région 118 qui, en raison du niveau de dopage obtenu, a une conductivité électrique correspondant à celle d'un matériau électriquement conducteur. L'implantation ionique mise en oeuvre est telle que la concentration de dopants dans le semi-conducteur de la portion 104 reste inférieure ou égale à environ 1.10¹⁶ at.cm⁻³, et que la concentration de dopants dans le semi-conducteur de la région 118 soit supérieure ou égale à environ 1.10¹⁹ at.cm⁻³. Par exemple, lorsque l'épaisseur de la couche diélectrique enterrée 106 est égale à environ 145 nm, l'implantation ionique peut être réalisée avec une dose comprise entre environ 1.10¹³ at.cm⁻² et 5.10¹³ at.cm⁻² et une énergie comprise entre environ 250 keV et 300 keV.

Le masque 126 est ensuite retiré, puis les espaceurs 120 sont réalisés autour des grilles avant 110a, 110b (figures 6A et 6B). La longueur L_{SP} de chaque espaceur 120 est telle que la deuxième partie 116 de la portion 104 est recouverte par ces espaceurs 120 et que la distance entre les premières parties 108 de la portion 104 et les troisièmes parties 122 destinées à former les réservoirs de porteurs de charges soit supérieure ou égale à environ 20 nm. Ces espaceurs 120 sont réalisés de manière similaire à des espaceurs de grille d'un dispositif MOSFET.

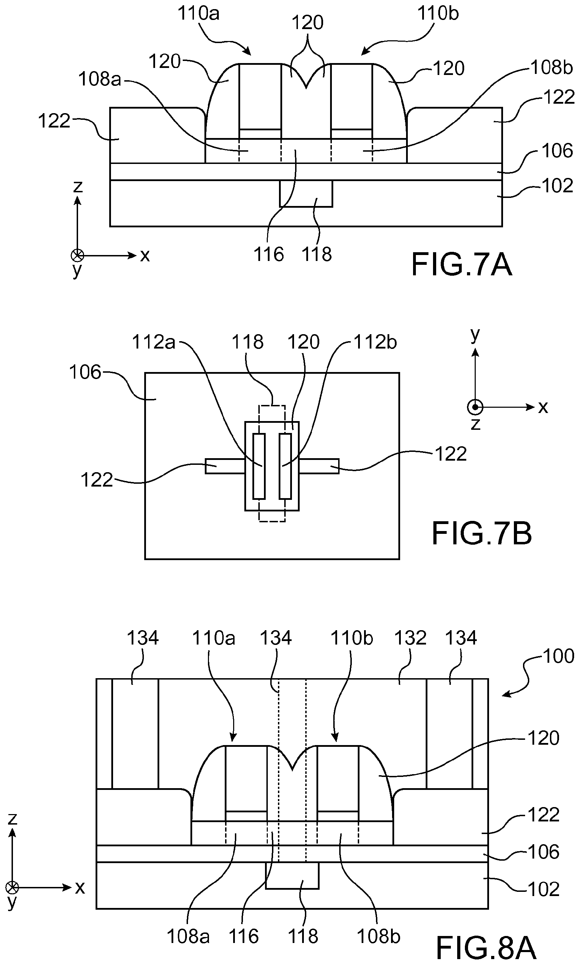

Les réservoirs de porteurs de charges sont ensuite réalisés, par exemple par épitaxie sur les parties de semi-conducteur de la portion 104 qui ne sont pas recouvertes par les grilles avant 110a, 110b et les espaceurs 120, puis par dopage (dopage in situ ou implantation ionique), formant les troisièmes parties 122 (figures 7A et 7B). En variante, il est possible il est possible que les troisième parties 122 soient obtenues sans mettre en oeuvre d'épitaxie. Les paramètres de l'implantation ionique pouvant réaliser le dopage du semi-conducteur des troisièmes parties 122 de la portion 104 sont tels que les dopants ne sont implantés que dans ce semi-conducteur et non dans la couche support 102, ces paramètres pouvant correspondre à une dose comprise entre environ 5.10¹⁴ at.cm⁻² et 5.10¹⁵ at.cm⁻² et une énergie inférieure à environ 10 keV.

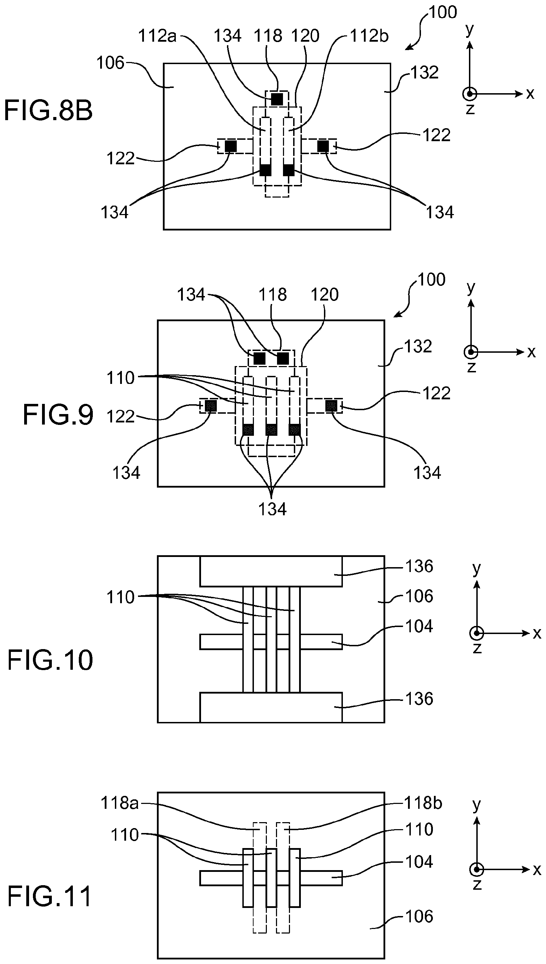

Comme représenté sur les figures 8A et 8B, la structure obtenue est ensuite encapsulée via le dépôt d'une couche d'encapsulation 132 recouvrant tous les éléments réalisés précédemment. Des contacts électriques 134 sont ensuite réalisés afin de former des accès électriques aux troisièmes parties 122, aux grilles avant 110a, 110b ainsi qu'à la région 118. Le contact électrique 134 relié à la région 118 (représenté en trait pointillé sur la figure 8A) est formé à côté des espaceurs 120 et traverse la couche d'encapsulation 132 et la couche diélectrique enterrée 106. Une siliciuration des contacts électriques peut également être mise en oeuvre à ce stade du procédé.

Dans le premier mode de réalisation décrit ci-dessus, deux régions de confinement de deux qubits sont couplées en série l'une à l'autre via la deuxième partie 116 de la portion 104 se trouvant entre ces deux régions de confinement, la région dopée 118 formant une grille arrière permettant de contrôler ce couplage. En variante, il est possible que le dispositif 100 comporte un plus grand nombre de qubits couplés les uns aux autres deux à deux. Dans ce cas, plusieurs grilles avant 110 sont réalisées les unes à côté des autres, chacune recouvrant notamment une première partie 108 de la portion 104 formant une région de confinement d'un des qubits. La figure 9 correspond à une vue de dessus du dispositif 100 selon une telle variante. La région 118 ainsi réalisée, selon le procédé précédemment décrit, permet alors de moduler le couplage pour l'ensemble des deuxièmes parties formant les portions de couplage entre les régions de confinement des qubits.

Lorsque le dispositif 100 comporte plus de deux qubits couplés les uns aux autres, il est toutefois avantageux de réaliser ce dispositif 100 tel que le couplage réalisé par chaque deuxième partie 116 soit modulable indépendamment les uns des autres par plusieurs régions 118 indépendantes, ou distinctes, chacun associée à l'une des deuxièmes parties 116. Ces différentes régions 118 ne sont dans ce cas pas en contact les unes avec les autres. Pour cela, lors de l'implantation ionique de dopants dans la couche support 102 pour former ces régions 118, il est possible de réaliser au préalable un masquage supplémentaire au niveau des extrémités des grilles avant afin que les parties de la couche support 102 recevant ces dopants correspondent uniquement à celles localisées entre les parties de la couche 102 disposées sous les grilles avant 110 (voir la figure 10 sur laquelle des masques 136 supplémentaires recouvrent les parties de la structure au niveau des extrémités des grilles avant 110). L'implantation ensuite mise en oeuvre forme autant de régions 118 que de deuxièmes parties 116. Ces différentes régions 118 peuvent être commandées indépendamment les unes des autres grâce aux différents contacts électriques 134 réalisés ensuite et reliés à chacune d'elles. Pour la réalisation des contacts électriques 134 reliés aux régions 118, une gravure préalable des extrémités des grilles avant 110 est avantageuse, comme représenté sur la figure 11, afin de dégager l'accès aux zones des contacts des régions 118 ainsi réalisées. Sur la figure 11, le dispositif 100 comporte trois qubits dont les régions de confinement sont couplées deux à deux par deux deuxièmes parties 116. Deux régions dopées 118a, 118b indépendantes l'une de l'autre sont ainsi réalisées, chacune permettant de commander le couplage de la deuxième partie 116 de la portion 104 qui est disposée au-dessus de cette région 118.

Dans les exemples de réalisation précédemment décrits, les grilles avants 110 sont réalisées sur la portion 104 préalablement à la réalisation de la région dopée 118. En variante, il est possible que les grilles avant 110 soient réalisées après la région 118. Toutefois, afin que la région 118 soit bien réalisée de manière auto-alignée vis-à-vis de ces grilles avant 110, des grilles factices (« dummy gates ») peuvent dans ce cas être réalisées préalablement à la réalisation de la région 118, aux emplacements prévus pour les grilles avant 110. La ou les régions dopées 118 sont ensuite réalisées de manière auto-alignée vis-à-vis de ces grilles factices. Les espaceurs 120 sont alors réalisés puis ces grilles factices sont supprimées et remplacées par les grilles avant 110 définitives.

## Revendications

1. Dispositif quantique (100) à au moins deux qubits de spin, comportant au moins :
- une portion de semi-conducteur (104) comportant une dimension principale selon une première direction (X) et disposée sur une couche diélectrique enterrée (106) d'un substrat de type semi-conducteur sur isolant comprenant en outre une couche support (102) de semi-conducteur telle que la couche diélectrique enterrée (106) soit disposée entre la portion de semi-conducteur (104) et la couche support (102), dans laquelle au moins deux premières parties (108a, 108b) distinctes forment chacune une région de confinement d'un des au moins deux qubits et sont espacées l'une de l'autre par au moins une deuxième partie (116) formant une région de couplage entre les régions de confinement des au moins deux qubits ;
- au moins deux grilles avant (110) comportant une dimension principale selon une deuxième direction (Y) perpendiculaire à la première direction et croisant la portion de semi-conducteur en vue de dessus, une portion intermédiaire de chacune des au moins deux grilles avant (110) recouvrant une des au moins deux premières parties (108a, 108b) de la portion de semi-conducteur (104) ;
**caractérisé en ce que**
la couche support (102) comporte au moins une région dopée (118) dont au moins une partie est disposée à l'aplomb de l'au moins une deuxième partie (116) de la portion de semi-conducteur (104) et alignée vis-à-vis des grilles avant (110) telle que des bords d'une projection de l'au moins une région dopée (118) dans un plan parallèle à l'interface entre la couche support (102) et la couche diélectrique enterrée (106) sont alignés avec ceux d'une projection des grilles avant (110) dans ledit plan, et forme au moins une grille arrière de commande du couplage entre les régions de confinement des au moins deux qubits.

2. Dispositif quantique (100) selon la revendication 1, dans lequel la portion de semi-conducteur (104) comporte en outre au moins deux troisièmes parties (122) dopées entre lesquelles sont disposées les au moins deux premières et l'au moins une deuxième parties (108a, 108b, 116) et formant des réservoirs de porteurs de charges électriques des qubits.

3. Dispositif quantique (100) selon l'une des revendications précédentes, dans lequel les au moins deux, premières et l'au moins une deuxième parties (108a, 108b, 116) de la portion de semi-conducteur (104) comportent un dopage résiduel inférieur ou égal à environ 1.10¹⁶ at.cm⁻³, et l'au moins une région dopée (118) de la couche support (102) comporte un dopage supérieur ou égal à environ 1.10¹⁹ at.cm⁻³.

4. Dispositif quantique (100) selon l'une des revendications précédentes, comportant en outre des espaceurs diélectriques (122) entourant chacune des grilles avant (110) et recouvrant l'au moins une deuxième partie (116) de la portion de semi-conducteur (104).

5. Dispositif quantique (100) selon l'une des revendications précédentes, dans lequel l'au moins une région dopée (118) comporte au moins une zone de contact disposée à côté de ladite au moins une partie se trouvant à l'aplomb de l'au moins une deuxième partie (116) de la portion de semi-conducteur (104), et reliée électriquement à au moins un contact électrique (134) qui traverse au moins la couche diélectrique enterrée (106).

6. Dispositif quantique (100) selon l'une des revendications précédentes, dans lequel la couche support (102) comporte plusieurs régions dopées (118a, 118b) formant plusieurs grilles arrière de commande du couplage entre des régions de confinement de plusieurs qubits.

7. Dispositif quantique (100) selon la revendication 6, dans lequel chacune des régions dopées (118a, 118b) comporte au moins une zone de contact reliée électriquement à un contact électrique (134) individuel compatible avec un adressage individuel des grilles arrières.

8. Procédé de réalisation d'un dispositif quantique (100) à au moins deux qubits de spin, comportant au moins :
- réalisation d'au moins deux grilles avant (110) telles qu'une portion intermédiaire de chacune des au moins deux grilles avant (110) recouvre une d'au moins deux premières parties (108a, 108b) distinctes d'une portion de semi-conducteur (104) comportant une dimension principale selon une première direction (X) et disposée sur une couche diélectrique enterrée (106) d'un substrat de type semi-conducteur sur isolant qui comprend en outre une couche support (102) de semi-conducteur telle que la couche diélectrique enterrée (106) soit disposée entre la portion de semi-conducteur (104) et la couche support (102), les au moins deux premières parties (108a, 108b) étant chacune destinée à former une région de confinement d'un des au moins deux qubits et étant espacées l'une de l'autre par au moins une deuxième partie (116) de la portion de semi-conducteur (104) destinée à former une région de couplage entre les régions de confinement des au moins deux qubits, les au moins deux grilles avant (110) comportant une dimension principale selon une deuxième direction (Y) perpendiculaire à la première direction et croisant la portion de semi-conducteur en vue de dessus, le procédé étant **caractérisé en ce que**, après la réalisation des au moins deux grille avant, il comporte
- dopage d'au moins une région (118) de la couche support (102), dont au moins une partie est disposée à l'aplomb de l'au moins une deuxième partie (116) de la portion de semi-conducteur (104) et est auto-alignée vis-à-vis des grilles avant, et est destinée à former au moins une grille arrière de commande du couplage entre les régions de confinement des au moins deux qubits.

9. Procédé selon la revendication 8, comportant, avant le dopage de la région (118) de la couche support (102), une réalisation d'au moins deux grilles factices recouvrant chacune au moins partiellement une des au moins deux premières parties (108a, 108b) de la portion de semi-conducteur (104), puis, après le dopage de l'au moins une région (118) de la couche support (102), une suppression des grilles factices puis la réalisation des grilles avant (110) à des emplacements correspondant à ceux occupés par les grilles factices.

10. Procédé selon l'une des revendications 8 et 9, dans lequel le dopage de l'au moins une région (118) de la couche support (102) comporte la mise en oeuvre des étapes suivantes :
- réalisation d'un masque (126) comprenant au moins une ouverture (128) formée à travers le masque (126) ;
- implantation de dopants dans ladite au moins une région (118) de la couche support (102) dont le motif est défini par celui de l'ouverture (128) traversant le masque (126) et par celui des grilles avant (110) ou des grilles factices.

11. Procédé selon l'une des revendications 8 à 10, comportant en outre, avant la réalisation des grilles avant (110) ou des grilles factices, une étape de gravure d'une couche superficielle (124) de semi-conducteur du substrat, au moins une portion restante de la couche superficielle (124) formant la portion de semi-conducteur (104).

12. Procédé selon l'une des revendications 8 à 11, comportant en outre, après l'étape de dopage de ladite au moins une région (118) de la couche support (102), les étapes de :
- réalisation d'espaceurs diélectriques (122) entourant chacune des grilles avant (110) ou des grilles factices et recouvrant l'au moins une deuxième partie (116) de la portion de semi-conducteur (104) ;
- dopage d'au moins deux troisièmes parties (122) de la portion de semi-conducteur (104) entre lesquelles sont disposées les au moins deux premières et l'au moins une deuxième parties (108a, 108b, 116) et destinées à former des réservoirs de porteurs de charges électriques.

13. Procédé selon l'une des revendications 8 à 12, dans lequel les étapes mises en oeuvre forment plusieurs régions dopées (118a, 118b) de la couche support (102) formant plusieurs grilles arrière de commande du couplage entre des régions de confinement de plusieurs qubits.

14. Procédé selon la revendication 13, comportant en outre la réalisation de plusieurs contacts électriques (134) individuels chacun relié électriquement à une zone de contact d'une des régions dopées (118a, 118b) de la couche support (102) et compatible avec un adressage individuel des grilles arrières.

## Patentansprüche

1. Quantenvorrichtung (100) mit mindestens zwei Spin-Qubits, die mindestens umfasst:
- einen Halbleiterabschnitt (104), der eine Hauptabmessung in einer ersten Richtung (X) umfasst und auf einer eingebetteten dielektrischen Schicht (106) eines Substrats vom Typ Halbleiter-auf-Isolator angeordnet ist, das weiter eine Halbleiter-Trägerschicht (102) so umfasst, dass die eingebettete dielektrische Schicht (106) zwischen dem Halbleiterabschnitt (104) und der Trägerschicht (102) angeordnet ist, wobei mindestens zwei separate erste Teile (108a, 108b) jeweils eine Einschlussregion für eines der mindestens zwei Qubits bilden und durch mindestens einen zweiten Teil (116), der eine Kopplungsregion zwischen den Einschlussregionen der mindestens zwei Qubits bildet, voneinander beabstandet sind;
- mindestens zwei vordere Gatter (110), die eine Hauptabmessung in einer zur ersten Richtung senkrecht stehenden zweiten Richtung (Y) umfassen und den Halbleiterabschnitt von oben gesehen kreuzen, wobei ein Zwischenabschnitt jedes der mindestens zwei vorderen Gatter (110) einen der mindestens zwei ersten Teile (108a, 108b) des Halbleiterabschnitts (104) bedeckt;
**dadurch gekennzeichnet, dass**
die Trägerschicht (102) mindestens eine dotierte Region (118) umfasst, von der mindestens ein Teil lotrecht unter dem mindestens einen zweiten Teil (116) des Halbleiterabschnitts (104) angeordnet und den vorderen Gattern (110) gegenüber so ausgerichtet ist, dass Ränder einer Projektion der mindestens einen dotierten Region (118) in einer zur Grenzfläche zwischen der Trägerschicht (102) und der eingebetteten dielektrischen Schicht (106) parallelen Ebene zu denen einer Projektion der vorderen Gatter (110) in der Ebene ausgerichtet sind, und die mindestens ein hinteres Gatter zum Steuern der Kopplung zwischen den Einschlussregionen der mindestens zwei Qubits bildet.

2. Quantenvorrichtung (100) nach Anspruch 1, wobei der Halbleiterabschnitt (104) weiter mindestens zwei dritte dotierte Teile (122) umfasst, zwischen denen die mindestens zwei ersten und der mindestens eine zweite Teil (108a, 108b, 116) angeordnet sind und die Reservoirs für elektrische Ladungsträger der Qubits bilden.

3. Quantenvorrichtung (100) nach einem der vorstehenden Ansprüche, wobei die mindestens zwei ersten und der mindestens eine zweite Teil (108a, 108b, 116) des Halbleiterabschnitts (104) eine Restdotierung von kleiner oder gleich etwa 1.10¹⁶ at.cm⁻³ umfassen, und die mindestens eine dotierte Region (118) der Trägerschicht (102) eine Dotierung von größer oder gleich etwa 1.10¹⁹ at.cm⁻³ umfasst.

4. Quantenvorrichtung (100) nach einem der vorstehenden Ansprüche, die weiter dielektrische Abstandshalter (122) umfasst, die jedes der vorderen Gatter (110) umgeben und den mindestens einen zweiten Teil (116) des Halbleiterabschnitts (104) bedecken.

5. Quantenvorrichtung (100) nach einem der vorstehenden Ansprüche, wobei die mindestens eine dotierte Region (118) mindestens eine Kontaktzone umfasst, die neben dem mindestens einen Teil, der sich lotrecht unter dem mindestens einen zweiten Teil (116) des Halbleiterabschnitts (104) befindet, angeordnet und elektrisch mit mindestens einem elektrischen Kontakt (134), der mindestens durch die eingebettete dielektrische Schicht (106) hindurchgeht, verbunden ist.

6. Quantenvorrichtung (100) nach einem der vorstehenden Ansprüche, wobei die Trägerschicht (102) mehrere dotierte Regionen (118a, 118b) umfasst, die mehrere hintere Gatter zum Steuern der Kopplung zwischen Einschlussregionen mehrerer Qubits bilden.

7. Quantenvorrichtung (100) nach Anspruch 6, wobei jede der dotierten Regionen (118a, 118b) mindestens eine Kontaktzone umfasst, die elektrisch mit einem elektrischen Einzelkontakt (134), der mit einer Einzeladressierung der hinteren Gatter kompatibel ist, verbunden ist.

8. Verfahren zur Herstellung einer Quantenvorrichtung (100) mit mindestens zwei Spin-Qubits, das mindestens umfasst:
- Herstellen von mindestens zwei vorderen Gattern (110) so, dass ein Zwischenabschnitt jedes der mindestens zwei vorderen Gatter (110) einen von mindestens zwei separaten ersten Teilen (108a, 108b) eines Halbleiterabschnitts (104) bedeckt, der eine Hauptabmessung in einer ersten Richtung (X) umfasst und auf einer eingebetteten dielektrischen Schicht (106) eines Substrats vom Typ Halbleiter-auf-Isolator angeordnet ist, das weiter eine Halbleiter-Trägerschicht (102) so umfasst, dass die eingebettete dielektrische Schicht (106) zwischen dem Halbleiterabschnitt (104) und der Trägerschicht (102) angeordnet ist, wobei die mindestens zwei ersten Teile (108a, 108b) jeweils dazu bestimmt sind, eine Einschlussregion für eines der mindestens zwei Qubits zu bilden und durch mindestens einen zweiten Teil (116) des Halbleiterabschnitts (104), der dazu bestimmt ist, eine Kopplungsregion zwischen den Einschlussregionen der mindestens zwei Qubits zu bilden, voneinander beabstandet sind, wobei die mindestens zwei vorderen Gatter (110) eine Hauptabmessung in einer zur ersten Richtung senkrecht stehenden zweiten Richtung (Y) umfassen und den Halbleiterabschnitt von oben gesehen kreuzen, wobei das Verfahren **dadurch gekennzeichnet ist, dass** es nach dem Herstellen der mindestens zwei vorderen Gatter umfasst
- Dotieren mindestens einer Region (118) der Trägerschicht (102), von der mindestens ein Teil lotrecht unter dem mindestens einen zweiten Teil (116) des Halbleiterabschnitts (104) angeordnet ist und sich gegenüber den vorderen Gattern selbst ausrichtet, und die dazu bestimmt ist, mindestens ein hinteres Gatter zum Steuern der Kopplung zwischen den Einschlussregionen der mindestens zwei Qubits zu bilden.

9. Verfahren nach Anspruch 8, das vor dem Dotieren der Region (118) der Trägerschicht (102) ein Herstellen von mindestens zwei Dummy-Gattern, die jeweils mindestens teilweise einen der mindestens zwei ersten Teile (108a, 108b) des Halbleiterabschnitts (104) bedecken, und anschließend nach dem Dotieren der mindestens einen Region (118) der Trägerschicht (102) ein Beseitigen der Dummy-Gatter und anschließend das Herstellen der vorderen Gatter (110) an Stellen, die den von den Dummy-Gattern eingenommenen entsprechen, umfasst.

10. Verfahren nach einem der Ansprüche 8 und 9, wobei das Dotieren der mindestens einen Region (118) der Trägerschicht (102) das Umsetzen der folgenden Schritte umfasst:
- Herstellen einer Maske (126), die mindestens eine durch die Maske (126) hindurch gebildete Öffnung (128) umfasst;
- Implantieren von Dotierstoffen in die mindestens eine Region (118) der Trägerschicht (102), deren Struktur durch die der durch die Maske (126) hindurchgehenden Öffnung (128) und durch die der vorderen Gatter (110) oder der Dummy-Gatter definiert ist.

11. Verfahren nach einem der Ansprüche 8 bis 10, das vor dem Herstellen der vorderen Gatter (110) oder der Dummy-Gatter weiter einen Schritt des Ätzens einer oberflächlichen Halbleiterschicht (124) des Substrats umfasst, wobei mindestens ein verbleibender Abschnitt der oberflächlichen Schicht (124) den Halbleiterabschnitt (104) bildet.

12. Verfahren nach einem der Ansprüche 8 bis 11, das nach dem Schritt des Dotierens der mindestens einen Region (118) der Trägerschicht (102) weiter die folgenden Schritte umfasst:
- Herstellen von dielektrischen Abstandshaltern (122), die jedes der vorderen Gatter (110) oder der Dummy-Gatter umgeben und den mindestens einen zweiten Teil (116) des Halbleiterabschnitts (104) bedecken;
- Dotieren von mindestens zwei dritten Teilen (122) des Halbleiterabschnitts (104), zwischen denen die mindestens zwei ersten und der mindestens eine zweite Teil (108a, 108b, 116) angeordnet sind und die dazu bestimmt sind, Reservoirs für elektrische Ladungsträger zu bilden.

13. Verfahren nach einem der Ansprüche 8 bis 12, wobei die umgesetzten Schritte mehrere dotierte Regionen (118a, 118b) der Trägerschicht (102) bilden, die mehrere hintere Gatter zum Steuern der Kopplung zwischen Einschlussregionen mehrerer Qubits bilden.

14. Verfahren nach Anspruch 13, das weiter das Herstellen von mehreren elektrischen Einzelkontakten (134) umfasst, die jeweils elektrisch mit einer Kontaktzone einer der dotierten Regionen (118a, 118b) der Trägerschicht (102) verbunden und mit einer Einzeladressierung der hinteren Gatter kompatibel sind.

## Claims

1. Quantum device (100) with at least two spin qubits, comprising at least:
- a semiconductor portion (104) comprising a main dimension according to a first direction (X) and arranged on a buried dielectric layer (106) of a semiconductor-on-insulator type substrate which further comprises a semiconductor support layer (102) such that the buried dielectric layer (106) is arranged between the semiconductor portion (104) and the support layer (102), wherein at least two first distinct parts (108a, 108b) each form a confinement region of one of the at least two qubits and are spaced apart from one another by at least one second part (116) forming a coupling region between the confinement regions of the at least two qubits;
- at least two front gates (110) comprising a main dimension according to a second direction (Y) perpendicular to the first direction and crossing the semiconductor portion in a top view, an intermediate part of each of the at least two front gates (110) covering one of the at least two first parts (108a, 108b) of the semiconductor portion (104) ;
**characterized in that**
the support layer (102) comprises at least one doped region (118) with at least a part arranged in line with the at least one second part (116) of the semiconductor portion (104) and aligned with respect to the front gates (110) such that edges of a projection of the at least one doped region (118) in a plane which is parallel to the interface between the support layer (102) and the buried dielectric layer (106) are aligned with those of a projection of the front gates (110) in said plane, thereby forming at least one back gate controlling coupling between the confinement regions of the at least two qubits.

2. Quantum device (100) according to claim 1, wherein the semiconductor portion (104) further comprises at least two doped third parts (122) between which the at least two first parts and the at least one second part (108a, 108b, 116) and forming electrical charge carrier reservoirs of qubits.

3. Quantum device (100) according to one of the previous claims, wherein the at least two first parts and the at least one second part (108a, 108b, 116) of the semiconductor portion (104) comprise a residual doping less than or equal to around 1.10¹⁶ at.cm⁻³, and the at least one doped region (118) of the support layer (102) comprises a doping higher than or equal to around 1.10¹⁹ at.cm⁻³.

4. Quantum device (100) according to one of the previous claims, further comprising dielectric spacers (122) surrounding each of the front gates (110) and covering the at least one second part (116) of the semiconductor portion (104).

5. Quantum device (100) according to one of the previous claims, wherein the at least one doped region (118) comprises at least one contact area arranged next to said at least one part arranged in line with the at least one second part (116) of the semiconductor portion (104), and electrically connected to at least one electrical contact (134) crossing at least the buried dielectric layer (106).

6. Quantum device (100) according to one of the previous claims, wherein the support layer (102) comprises several doped regions (118a, 118b) forming several back gates controlling the coupling between confinement regions of several qubits.

7. Quantum device (100) according to claim 6, wherein each of the doped regions (118a, 118b) comprises at least one contact area electrically connected to an individual electrical contact (134) which is compatible with an individual addressing of the back gates.

8. Method for producing a quantum device (100) with at least two spin qubits, comprising at least:
- producing at least two front gates (110) such that an intermediate part of each of the at least two front gates (110) covers one of the at least two first distinct parts (108a, 108b) of a semiconductor portion (104) comprising a main dimension according to a first direction (X) and arranged on a buried dielectric layer (106) of a semiconductor-on-insulator type substrate which further comprises a semiconductor support layer (102) such that the buried dielectric layer (106) is arranged between the semiconductor portion (104) and the support layer (102), the at least two first parts (108a, 108b) each being intended to form a confinement region of one of the at least two qubits and being spaced apart from one another by at least one second part (116) of the semiconductor portion (104) intended to form a coupling region between the confinement regions of the at least two qubits, the at least two front gates (110) comprising a main dimension according to a second direction (Y) perpendicular to the first direction and crossing the semiconductor portion in a top view, the method being **characterized in that**, after the making of the at least two front gates, it comprises
- doping at least one region (118) of the support layer (102), at least one part of which being arranged in line with the at least one second part (116) of the semiconductor portion (104) and is self-aligned with respect to the front gates, and is intended to form at least one back gate controlling coupling between the confinement regions of the at least two qubits.

9. Method according to claim 8, comprising, before the doping of the region (118) of the support layer (102), producing at least two dummy gates, each at least partially covering one of the at least two first parts (108a, 108b) of the semiconductor portion (104), then, after the doping of the at least one region (118) of the support layer (102), eliminating the dummy gates, and the producing of the front gates (110) at locations corresponding to those occupied by the dummy gates.

10. Method according to one of claims 8 and 9, wherein the doping of the at least one region (118) of the support layer (102) comprises the following steps:
- producing a mask (126) including at least one opening (128) formed through the mask (126);
- implanting dopants in said at least one region (118) of the support layer (102) wherein the pattern of which is defined by that of the opening (118) passing through the mask (126) and by that of the front gates (110) or of the dummy gates.

11. Method according to one of claims 8 to 10, further comprising, before the producing of the front gates (110) and the dummy gates, an etching step of a semiconductor surface layer (124) of the substrate, at least one remaining portion of the surface layer (124) forming the semiconductor portion (104).

12. Method according to one of claims 8 to 11, further comprising, after the doping step of said at least one region (118) of the support layer (102), the steps of:
- producing dielectric spacers (122) surrounding each of the front gates (110) or dummy gates and covering the at least one second part (116) of the semiconductor portion (104);
- doping at least two third parts (122) of the semiconductor portion (104) between which the at least two first parts and the at least one second part (108a, 108b, 116) are arranged and intended to form electrical charge carrier reservoirs.

13. Method according to one of claim 8 to 12, wherein the implemented steps form several doped regions (118a, 118b) of the support layer (102) forming several back gates controlling the coupling between the confinement regions of several qubits.

14. Method according to claim 13, further comprising producing several individual electrical contacts (134) each electrically connected to a contact area of one of the doped regions (118a, 118b) of the support layer (102) and compatible with an individual addressing of the back gates.
